# EUROPEAN PATENT APPLICATION

(11) **EP 4 571 806 A1**
(43) Date of publication of application: **18.06.2025**
(21) Application number: 23215932.7
(22) Date of filing: 12.12.2023
(51) Int. Cl.: H01H 11/00, H01H 1/00, H01H 3/26

(54) **SYSTEM FOR MONITORING A SWITCHGEAR**

(71) Applicant: ABB SCHWEIZ AG, 5400 Baden (CH)
(72) Inventor: GITZEL, Ralf, 68165 Mannheim (DE); BOYACI, Aydin, 76337 Waldbronn (DE)
(74) Representative: Maiwald GmbH

(57) **Abstract**

The present invention relates to an apparatus for determining a time of contact of contacts of a circuit breaker, the apparatus comprising: an input unit (30);a processing unit (40); and an output unit (50);
wherein the input unit is configured to receive displacement data as a function of time of a moveable contact of a circuit breaker (10) with respect to a fixed contact of the circuit breaker during a closing operation of the circuit breaker;
wherein the input unit is configured to provide the displacement data as a function of time to the processing unit;
wherein the processing unit is configured to determine a displacement curve as a function of time, wherein the displacement curve as a function of time is determined by a curve fit to the displacement data as a function of time;
wherein the processing unit is configured to determine a time of contact of the moveable contact with the fixed contact, wherein the determination comprises a determination of a region of the displacement curve as a function of time, wherein the determination of the region comprises a determination that a gradient of the region of the displacement curve as a function of time is less than a gradient of the displacement curve as a function of time at a time earlier than a time associated with the region of the displacement curve as a function of time, wherein the determination of the region comprises a determination that the gradient of the region of the displacement curve as a function of time is less than a gradient of the displacement curve as a function of time at a time later than the time associated with the region of the displacement curve as a function of time, and wherein the time associated with the region of the displacement curve as a function of time is determined as the time of contact of the moveable contact with the fixed contact; and
wherein the output unit is configured to output the time of contact of the moveable contact with the fixed contact.

## Description

### FIELD OF THE INVENTION

The present invention relates to an apparatus for determining a time of contact of contacts of a circuit breaker, an apparatus for determining a time of breaking of contact of contacts of a circuit breaker, a system for determining a time of contact of contacts of a circuit breaker, a system for determining a time of breaking of contact of contacts of a circuit breaker, a method for determining a time of contact of contacts of a circuit breaker, a method for determining a time of breaking of contact of contacts of a circuit breaker, and a computer program element.

### BACKGROUND OF THE INVENTION

The opening and closing times of circuit breakers are important key performance indicators of breaker health. They can be computed if the time instant of making or breaking the contact can be determined. Relevant information about the opening and closing operation can be extracted from the travel curve. The travel curve describes the stroke of the moving contact There are sensors that can measure the travel curve or an approximation of the travel curve based on other values that in turn can be used to compute the travel curve. Some examples are position sensors and rotary encoders. One typical approach is to use position sensors to measure the stroke of the push rod. Another typical approach is to measure the angle of the main shaft which is connected with the poles via a linkage. The measured main shaft angle can be transformed by kinematical relationships into the stroke of the push rod. The kinematical relationships result from the design of the linkage. The travel curve starts and ends in one of the two steady states, which represent the opened and the closed position of the electrical contacts.

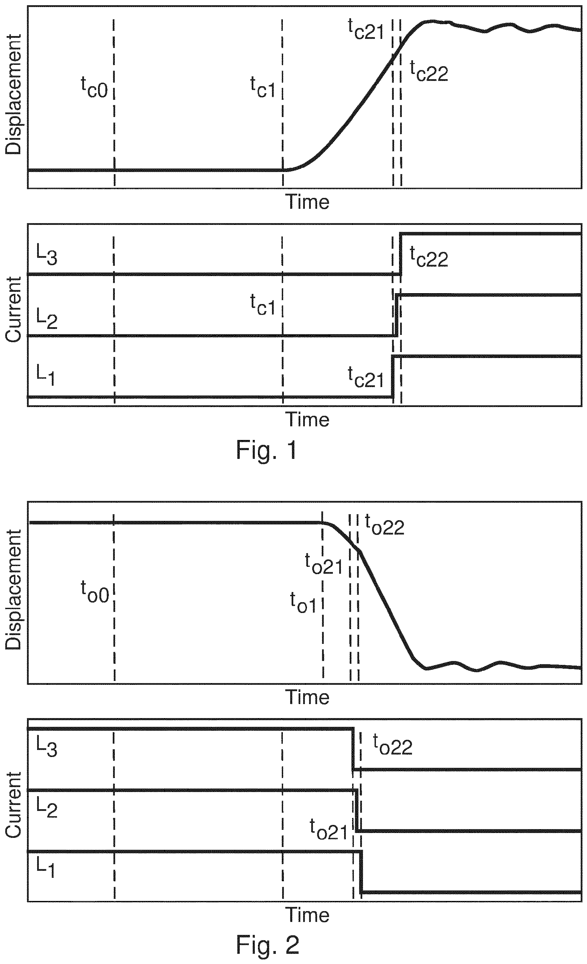

Fig. 1 illustrates time instants on the travel curve for the closing operation, where the following time are indicated:
t_{c0}: Initiation of closing operation - Current starts flowing through the closing coil.
t_{c1}: Instant when the moving contact starts travelling towards the fixed contact.
t_{c21}: Instant of contact touch (start of current flow) in the first pole. In Fig. 1, pole 1 closes first, therefore t_{c21} is defined by L₁.
T_{c22}: Instant when contacts remain closed (full current flow) in all three poles L₁, L₂ and
L₃. In Fig. 1, pole 3 closes last, therefore t_{c22} is defined by L₃.

In Fig.1 the currents shown in all poles for the closing operation give the time region of contact making between the two time instants t_{c21} and t_{c22}

Fig. 2 illustrates time instants on the travel curve for the opening operation, where the following time are indicated:
Tₒ₀: Initiation of opening operation - Current starts flowing through the trip coil.
Tₒ₁: Instant when the moving contact starts travelling backward for opening the contacts.
Tₒ₂₁: Instant of separation or breaking of contacts in the first pole. In Fig. 2, pole 3 opens first, therefore tₒ₂₁ is defined by L₃.
Tₒ₂₂: Instant of separation or breaking of contacts in all three poles. In Fig. 2, pole 1 opens last, therefore to₂₂ is defined by L₁.

Here the situation for three phases is described, but there can be just one circuit breaker operating.

However, without measuring the current flowing through the electrical contacts, it is very difficult to accurately and reproducibly determine the opening and closing times of a circuit breaker, that can be used as an indicator of the health of the circuit breaker.

There is a need to address this issue.

### SUMMARY OF THE INVENTION

Therefore, it would be advantageous to have an improved technique to help in determining the closing and opening time of a circuit breaker.

The object of the present invention is solved with the subject matter of the independent claims, wherein further embodiments are incorporated in the dependent claims.

In a first aspect, there is provided an apparatus for determining a time of contact of contacts of a circuit breaker, the apparatus comprising:
- an input unit;
- a processing unit; and
- an output unit.

The input unit is configured to receive displacement data as a function of time of a moveable contact of a circuit breaker with respect to a fixed contact of the circuit breaker during a closing operation of the circuit breaker. The input unit is configured to provide the displacement data as a function of time to the processing unit. The processing unit is configured to determine a displacement curve as a function of time, wherein the displacement curve as a function of time is determined by a curve fit to the displacement data as a function of time. The processing unit is configured to determine a time of contact of the moveable contact with the fixed contact, the determination comprises a determination of a region of the displacement curve as a function of time. The determination of the region comprises a determination that a gradient of the region of the displacement curve as a function of time is less than a gradient of the displacement curve as a function of time at a time earlier than a time associated with the region of the displacement curve as a function of time, and the determination of the region comprises a determination that the gradient of the region of the displacement curve as a function of time is less than a gradient of the displacement curve as a function of time at a time later than the time associated with the region of the displacement curve as a function of time. The time associated with the region of the displacement curve as a function of time is determined as the time of contact of the moveable contact with the fixed contact. The output unit is configured to output the time of contact of the moveable contact with the fixed contact.

It is to be noted that the displacement data can be linear displacement data or angular/rotational displacement data.

Thus, the displacement curve generated from curve fitting can be a linear displacement curve as a function of time or be angular/rotational curve as a function of time.

It is to be noted that a determination that the gradient of the region of the displacement curve as a function of time is less than a gradient of the displacement curve as a function of time at a time later than the time associated with the region of the displacement curve as a function of time refers to magnitudes of gradients. Thus, if displacement data were all multiplied by -1 the magnitude would still be less than that either side.

Thus, the inventors established that the travel curve of a moveable contact during closing of a circuit breaker exhibited a small dent or point of inflexion or drop in gradient of the curve before the gradient increased again and this dent represented the time point of the moveable contact contacting the fixed contact, which is normally very difficult to establish. This then enables the closing time of the circuit breaker to be monitored accurately without also having to monitor current flow, where the closing time can be used as an indicator of the health of the circuit breaker, in other words if it is operating correctly. With reference to Fig. 1 the new technique enables the time region of contact making only from the travel curves without knowing the current curves.

To put this another way the new technique utilizes an algorithm that can compute a time when contacts are closed, enabling closing times of circuit breakers to be determined, from the travel curve data by identifying a characteristic dent in the travel curve.

In an example, the input unit is configured to receive a first time point associated with a time earlier than an estimated time of contact of the moveable contact with the fixed contact and receive a second time point associated with a time later than the estimated time of contact of the moveable contact with the fixed contact. The input unit is configured to provide the first time point and the second time point to the processing unit. The processing unit is configured to determine the displacement curve as a function of time by the curve fit to the displacement data as a function of time from the first time point to the second time point.

In this way, the curve fitting can be made over a shorter range of the real data, within which the dent is to be found, thereby increasing the accuracy of the curve fitting over the important region of contact "dent", to enable the time of contact of the contacts to be more accurately determined. The estimated time can be provided from general operational information for the circuit breaker.

In an example, the determination of the curve fit to the displacement data as a function of time comprises utilization by the processing unit of a cubic spline process.

In an example, the determination of the curve fit to the displacement data as a function of time comprises utilization by the processing unit of a cubic spline interpolation process.

In an example, the processing unit is configured to generate a first derivative temporal curve of the displacement curve as a function of time, and the determination of the region of the displacement curve as a function of time comprises utilization of the first derivative temporal curve.

In a second aspect, there is provided an apparatus for determining a time of breaking of contact of contacts of a circuit breaker, the apparatus comprising:
- an input unit;
- a processing unit; and
- an output unit.

The input unit is configured to receive displacement data as a function of time of a moveable contact of a circuit breaker with respect to a fixed contact of the circuit breaker during an opening operation of the circuit breaker. The input unit is configured to provide the displacement data as a function of time to the processing unit. The processing unit is configured to determine a displacement curve as a function of time. The displacement curve as a function of time is determined by a curve fit to the displacement data as a function of time. The processing unit is configured to determine a time of breaking of contact of the moveable contact with the fixed contact, the determination comprises a determination of a region of the displacement curve as a function of time. The determination of the region comprises a determination that a gradient of the region of the displacement curve as a function of time is greater than a gradient of the displacement curve as a function of time at a time earlier than a time associated with the region of the displacement curve as a function of time, and the determination of the region comprises a determination that the gradient of the region of the displacement curve as a function of time is greater than a gradient of the displacement curve as a function of time at a time later than the time associated with the region of the displacement curve as a function of time. The time associated with the region of the displacement curve as a function of time is determined as the time of breaking of contact of the moveable contact with the fixed contact. The output unit is configured to output the time of breaking of contact of the moveable contact with the fixed contact.

It is to be noted that the displacement data can be linear displacement data or angular/rotational displacement data.

Thus, the displacement curve generated from curve fitting can be a linear displacement curve as a function of time or be angular/rotational curve as a function of time.

It is to be noted that a determination that the gradient of the region of the displacement curve as a function of time is greater than a gradient of the displacement curve as a function of time at a time later than the time associated with the region of the displacement curve as a function of time refers to magnitudes of gradients. Thus, if displacement data were all multiplied by -1 the magnitude would still be greater than that either side.

Thus, the inventors established that the travel curve of a moveable contact during opening of a circuit breaker exhibited a small dent or point of inflexion or increase in gradient of the curve before the gradient decreased again and this dent represented the time point of the moveable contact breaking contact with the fixed contact, which is normally very difficult to establish. This then enables the opening time of the circuit breaker to be monitored accurately without also having to monitor current flow, where the opening time can be used as an indicator of the health of the circuit breaker, in other words if it is operating correctly. With reference to Fig. 2 the new technique enables the time region of breaking of contact only from the travel curves without knowing the current curves.

To put this another way the new technique utilizes an algorithm that can compute a time when contacts are no longer in contact, enabling opening times of circuit breakers to be determined, from the travel curve data by identifying a characteristic dent in the travel curve.

In an example, the input unit is configured to receive a first time point associated with a time earlier than an estimated time of breaking of contact of the moveable contact with the fixed contact and receive a second time point associated with a time later than the estimated time of breaking of contact of the moveable contact from the fixed contact. The input unit is configured to provide the first time point and the second time point to the processing unit. The processing unit is configured to determine the displacement curve as a function of time by the curve fit to the displacement data as a function of time from the first time point to the second time point.

In this way, the curve fitting can be made over a shorter range of the real data, within which the dent is to be found, thereby increasing the accuracy of the curve fitting over the important region of breaking of contact "dent", to enable the time of breaking of contact of the contacts to be more accurately determined. The estimated time can be provided from general operational information for the circuit breaker.

In an example, the determination of the curve fit to the displacement data as a function of time comprises utilization by the processing unit of a cubic spline process.

In an example, the determination of the curve fit to the displacement data as a function of time comprises utilization by the processing unit of a cubic spline interpolation process.

In an example, the processing unit is configured to generate a first derivative temporal curve of the displacement curve as a function of time, and the determination of the region of the displacement curve as a function of time comprises utilization of the first derivative temporal curve.

In a third aspect, there is provided a system for determining a time of contact of contacts of a circuit breaker, the system comprising:
- a sensor;
- a processing unit; and
- an output unit;

The sensor is configured to acquire sensor data associated with a moveable contact of a circuit breaker with respect to a fixed contact of the circuit breaker during a closing operation of the circuit breaker. The sensor data is displacement data as a function of time of the moveable contact with respect to the fixed contact of the circuit breaker during the closing operation of the circuit breaker. The sensor is configured to provide the displacement data as a function of time to the processing unit. The processing unit is configured to determine a displacement curve as a function of time. The displacement curve as a function of time is determined by a curve fit to the displacement data as a function of time. The processing unit is configured to determine a time of contact of the moveable contact with the fixed contact, the determination comprises a determination of a region of the displacement curve as a function of time. The determination of the region comprises a determination that a gradient of the region of the displacement curve as a function of time is less than a gradient of the displacement curve as a function of time at a time earlier than a time associated with the region of the displacement curve as a function of time, and the determination of the region comprises a determination that the gradient of the region of the displacement curve as a function of time is less than a gradient of the displacement curve as a function of time at a time later than the time associated with the region of the displacement curve as a function of time. The time associated with the region of the displacement curve as a function of time is determined as the time of contact of the moveable contact with the fixed contact. The output unit is configured to output the time of contact of the moveable contact with the fixed contact.

It is to be noted that the displacement data can be linear displacement data or angular/rotational displacement data.

Thus, the displacement curve generated from curve fitting can be a linear displacement curve as a function of time or be angular/rotational curve as a function of time.

It is to be noted that a determination that the gradient of the region of the displacement curve as a function of time is less than a gradient of the displacement curve as a function of time at a time later than the time associated with the region of the displacement curve as a function of time refers to magnitudes of gradients. Thus, if displacement data were all multiplied by -1 the magnitude would still be less than that either side.

In a fourth aspect, there is provided a system for determining a time of breaking of contact of contacts of a circuit breaker, the system comprising:
- a sensor;
- a processing unit; and
- an output unit.

The sensor is configured to acquire sensor data associated with a moveable contact of a circuit breaker with respect to a fixed contact of the circuit breaker during an opening operation of the circuit breaker. The sensor data is displacement data as a function of time of the moveable contact with respect to the fixed contact of the circuit breaker during the opening operation of the circuit breaker. The sensor is configured to provide the displacement data as a function of time to the processing unit. The processing unit is configured to determine a displacement curve as a function of time, the displacement curve as a function of time is determined by a curve fit to the displacement data as a function of time. The processing unit is configured to determine a time of breaking of contact of the moveable contact with the fixed contact, the determination comprises a determination of a region of the displacement curve as a function of time. The determination of the region comprises a determination that a gradient of the region of the displacement curve as a function of time is greater than a gradient of the displacement curve as a function of time at a time earlier than a time associated with the region of the displacement curve as a function of time, and the determination of the region comprises a determination that the gradient of the region of the displacement curve as a function of time is greater than a gradient of the displacement curve as a function of time at a time later than the time associated with the region of the displacement curve as a function of time. The time associated with the region of the displacement curve as a function of time is determined as the time of breaking of contact of the moveable contact with the fixed contact. The output unit is configured to output the time of breaking of contact of the moveable contact with the fixed contact.

It is to be noted that the displacement data can be linear displacement data or angular/rotational displacement data.

Thus, the displacement curve generated from curve fitting can be a linear displacement curve as a function of time or be angular/rotational curve as a function of time.

It is to be noted that a determination that the gradient of the region of the displacement curve as a function of time is greater than a gradient of the displacement curve as a function of time at a time later than the time associated with the region of the displacement curve as a function of time refers to magnitudes of gradients. Thus, if displacement data were all multiplied by -1 the magnitude would still be greater than that either side.

In a fifth aspect, there is provided a method for determining a time of contact of contacts of a circuit breaker, the apparatus comprising:
receiving by an input unit displacement data as a function of time of a moveable contact of a circuit breaker with respect to a fixed contact of the circuit breaker during a closing operation of the circuit breaker;
providing by the input unit the displacement data as a function of time to a processing unit;
determining by the processing unit a displacement curve as a function of time, wherein the displacement curve as a function of time is determined by a curve fit to the displacement data as a function of time;
determining by the processing unit a time of contact of the moveable contact with the fixed contact, wherein the determining comprises determining a region of the displacement curve as a function of time, wherein the determining the region comprises determining that a gradient of the region of the displacement curve as a function of time is less than a gradient of the displacement curve as a function of time at a time earlier than a time associated with the region of the displacement curve as a function of time, wherein the determining the region comprises determining that the gradient of the region of the displacement curve as a function of time is less than a gradient of the displacement curve as a function of time at a time later than the time associated with the region of the displacement curve as a function of time, and wherein the time associated with the region of the displacement curve as a function of time is determined as the time of contact of the moveable contact with the fixed contact; and
outputting by an output unit the time of contact of the moveable contact with the fixed contact.

It is to be noted that the displacement data can be linear displacement data or angular/rotational displacement data.

Thus, the displacement curve generated from curve fitting can be a linear displacement curve as a function of time or be angular/rotational curve as a function of time.

It is to be noted that a determination that the gradient of the region of the displacement curve as a function of time is less than a gradient of the displacement curve as a function of time at a time later than the time associated with the region of the displacement curve as a function of time refers to magnitudes of gradients. Thus, if displacement data were all multiplied by -1 the magnitude would still be less than that either side.

In a sixth aspect, there is provided a method for determining a time of breaking of contact of contacts of a circuit breaker, the apparatus comprising:
receiving by an input unit displacement data as a function of time of a moveable contact of a circuit breaker with respect to a fixed contact of the circuit breaker during an opening operation of the circuit breaker;
providing by the input unit the displacement data as a function of time to a processing unit;
determining by the processing unit a displacement curve as a function of time, wherein the displacement curve as a function of time is determined by a curve fit to the displacement data as a function of time;
determining by the processing unit a time of breaking of contact of the moveable contact with the fixed contact, wherein the determining comprises determining a region of the displacement curve as a function of time, wherein the determining the region comprises determining that a gradient of the region of the displacement curve as a function of time is greater than a gradient of the displacement curve as a function of time at a time earlier than a time associated with the region of the displacement curve as a function of time, wherein the determining the region comprises determining that the gradient of the region of the displacement curve as a function of time is greater than a gradient of the displacement curve as a function of time at a time later than the time associated with the region of the displacement curve as a function of time, and wherein the time associated with the region of the displacement curve as a function of time is determined as the time of breaking of contact of the moveable contact with the fixed contact; and
outputting by an output unit the time of breaking of contact of the moveable contact with the fixed contact.

It is to be noted that the displacement data can be linear displacement data or angular/rotational displacement data.

Thus, the displacement curve generated from curve fitting can be a linear displacement curve as a function of time or be angular/rotational curve as a function of time.

It is to be noted that a determination that the gradient of the region of the displacement curve as a function of time is greater than a gradient of the displacement curve as a function of time at a time later than the time associated with the region of the displacement curve as a function of time refers to magnitudes of gradients. Thus, if displacement data were all multiplied by -1 the magnitude would still be greater than that either side.

According to another aspect, there is provided a computer program element controlling one or more of the systems as previously described which, if the computer program element is executed by a processor, is adapted to perform the method as previously described.

According to another aspect, there is provided a computer readable medium having stored a computer element as previously described.

The computer program element can for example be a software program but can also be a FPGA, a PLD or any other appropriate digital means.

The above aspects and examples will become apparent from and be elucidated with reference to the embodiments described hereinafter.

### BRIEF DESCRIPTION OF THE DRAWINGS

Exemplary embodiments will be described in the following with reference to the following drawings:
Fig. 1 shows an exemplar displacement travel curve for one pole during a closing operation, where the displacement axis can represent a linear displacement or represent an angular/rotational displacement, and associated currents for all three poles of a three phase system;
Fig. 2 shows an exemplar displacement travel curve for one pole during an opening operation, where the displacement axis can represent a linear displacement or represent an angular/rotational displacement, and associated currents for all three poles of a three phase system;
Fig, 3 shows an apparatus for determining a time of contact of contacts of a circuit breaker;
Fig, 4 shows a system for determining a time of contact of contacts of a circuit breaker;

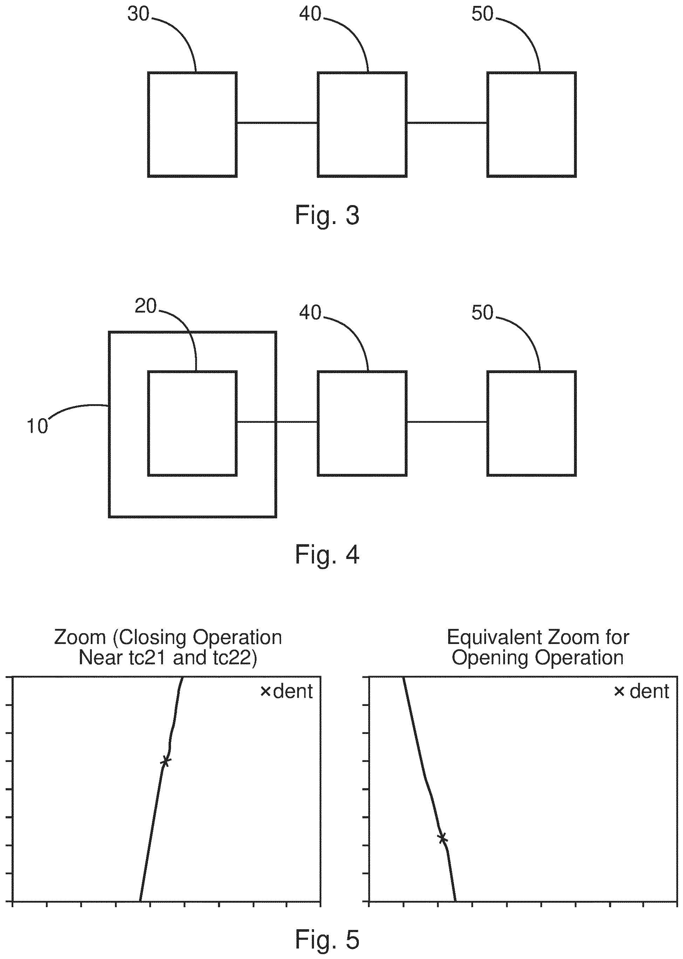

Fig. 5 shows an expanded portion of a travel curve during a closing operation showing a dent and an expanded portion of a travel curve during an opening operation showing a dent, where the y axis can represent a linear displacement or represent an angular/rotational displacement;
Fig, 6 shows a system for determining a time of contact (breaking of) of contacts of a circuit breaker;

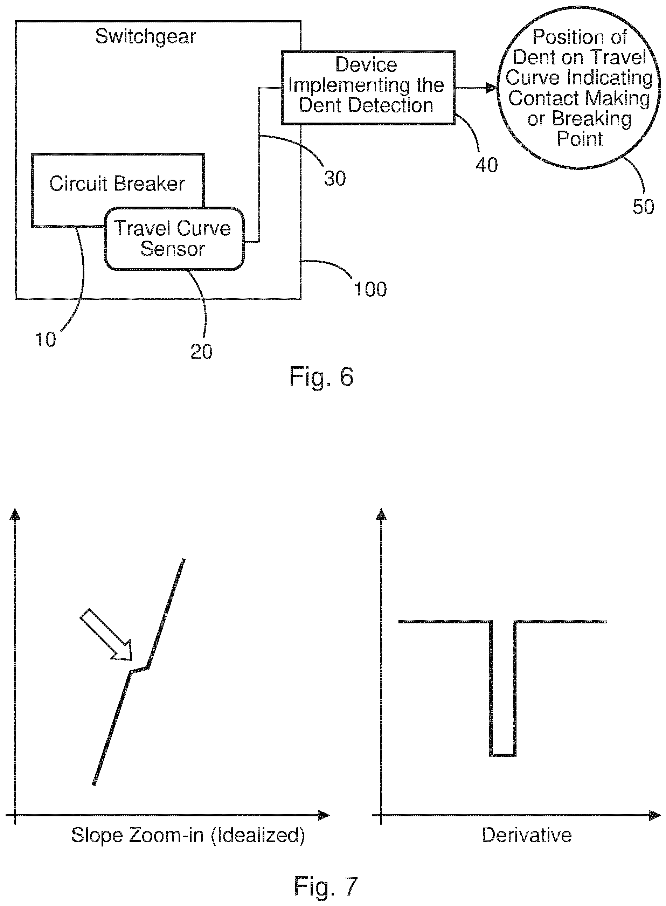

Fig. 7 shows an expanded portion of a travel curve during a closing operation showing a dent, where the y axis can represent a linear displacement or represent an angular/rotational displacement, and a first derivative of the expanded portion of the travel curve showing the dent clearly as a region of reduced gradient bounded by regions with higher gradients;

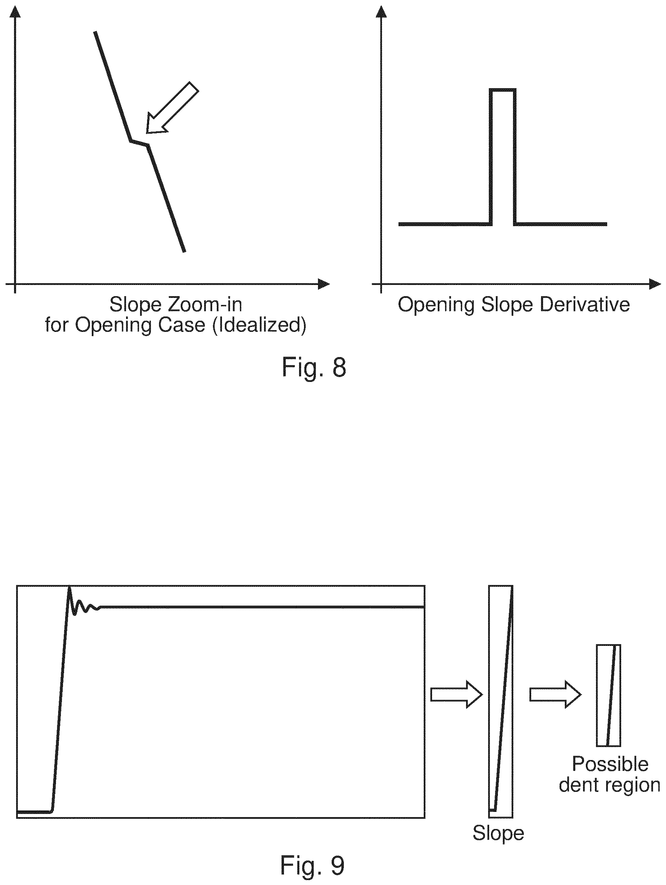

Fig. 8 shows an expanded portion of a travel curve during an opening operation showing a dent, where the y axis can represent a linear displacement or represent an angular/rotational displacement, and a first derivative of the expanded portion of the travel curve showing the dent clearly as a region of increased gradient bounded by regions with lower gradients;
Fig, 9 shows a travel curve during a closing operation, where the y axis can represent a linear displacement or represent an angular/rotational displacement, a first selected portion where the moveable contact is moving and a second selected portion around the region where the moveable contact is estimated to contact the fixed contact; and

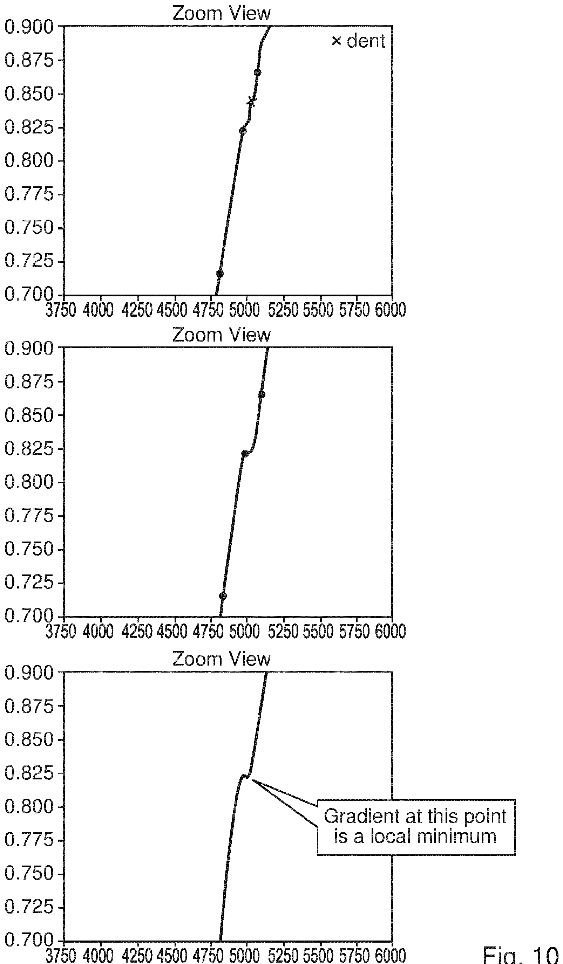

Fig. 10 shows a travel curve during a closing operation, where the y axis can represent a linear displacement or represent an angular/rotational displacement, a curve fitted to the travel curve, and finally just the curve fit itself.

### DETAILED DESCRIPTION OF EMBODIMENTS

Figs. 3-10 relate to the new apparatus, system and method for determining a time of contact of contacts of a circuit breaker, and the new apparatus, system and method for determining a time of breaking of contact of contacts of a circuit breaker, where reference is made back to Figs. 1-2.

Fig. 3 shows an example apparatus for determining a time of contact of contacts of a circuit breaker, the apparatus comprising:
- an input unit 30;
- a processing unit 40; and
- an output unit 50.

The input unit is configured to receive displacement data as a function of time of a moveable contact of a circuit breaker 10 with respect to a fixed contact of the circuit breaker during a closing operation of the circuit breaker. The input unit is configured to provide the displacement data as a function of time to the processing unit. The processing unit is configured to determine a displacement curve as a function of time. The displacement curve as a function of time is determined by a curve fit to the displacement data as a function of time. The processing unit is configured to determine a time of contact of the moveable contact with the fixed contact, the determination comprises a determination of a region of the displacement curve as a function of time. The determination of the region comprises a determination that a gradient of the region of the displacement curve as a function of time is less than a gradient of the displacement curve as a function of time at a time earlier than a time associated with the region of the displacement curve as a function of time, and the determination of the region comprises a determination that the gradient of the region of the displacement curve as a function of time is less than a gradient of the displacement curve as a function of time at a time later than the time associated with the region of the displacement curve as a function of time. The time associated with the region of the displacement curve as a function of time is determined as the time of contact of the moveable contact with the fixed contact. The output unit is configured to output the time of contact of the moveable contact with the fixed contact.

It is to be noted that the displacement data can be linear displacement data or angular/rotational displacement data.

Thus, the displacement curve generated from curve fitting can be a linear displacement curve as a function of time or be angular/rotational curve as a function of time.

It is to be noted that a determination that the gradient of the region of the displacement curve as a function of time is less than a gradient of the displacement curve as a function of time at a time later than the time associated with the region of the displacement curve as a function of time refers to magnitudes of gradients. Thus, if displacement data were all multiplied by -1 the magnitude would still be less than that either side.

Thus, the inventors established that the travel curve of a moveable contact during closing of a circuit breaker exhibited a small dent or point of inflexion or drop in gradient of the curve before the gradient increased again and this dent represented the time point of the moveable contact contacting the fixed contact, which is normally very difficult to establish. This then enables the closing time of the circuit breaker to be monitored accurately without also having to monitor current flow, where the closing time can be used as an indicator of the health of the circuit breaker, in other words if it is operating correctly. With reference to Fig. 1 the new technique enables the time region of contact making only from the travel curves without knowing the current curves.

To put this another way the new technique utilizes an algorithm that can compute a time when contacts are closed, enabling closing times of circuit breakers to be determined, from the travel curve data by identifying a characteristic dent in the travel curve.

According to an example, the input unit is configured to receive a first time point associated with a time earlier than an estimated time of contact of the moveable contact with the fixed contact and receive a second time point associated with a time later than the estimated time of contact of the moveable contact with the fixed contact. The input unit is configured to provide the first time point and the second time point to the processing unit. The processing unit is configured to determine the displacement curve as a function of time by the curve fit to the displacement data as a function of time from the first time point to the second time point.

In this way, the curve fitting can be made over a shorter range of the real data, within which the dent is to be found, thereby increasing the accuracy of the curve fitting over the important region of contact "dent", to enable the time of contact of the contacts to be more accurately determined. The estimated time can be provided from general operational information for the circuit breaker.

According to an example, the determination of the curve fit to the displacement data as a function of time comprises utilization by the processing unit of a cubic spline process.

According to an example, the determination of the curve fit to the displacement data as a function of time comprises utilization by the processing unit of a cubic spline interpolation process.

According to an example, the processing unit is configured to generate a first derivative temporal curve of the displacement curve as a function of time, and the determination of the region of the displacement curve as a function of time comprises utilization of the first derivative temporal curve.

Alternatively or additionally Fig. 3 also shows an apparatus for determining a time of breaking of contact of contacts of a circuit breaker, the apparatus comprising:
- an input unit 30;
- a processing unit 40; and
- an output unit 50.

The input unit is configured to receive displacement data as a function of time of a moveable contact of a circuit breaker 10 with respect to a fixed contact of the circuit breaker during an opening operation of the circuit breaker. The input unit is configured to provide the displacement data as a function of time to the processing unit. The processing unit is configured to determine a displacement curve as a function of time. The displacement curve as a function of time is determined by a curve fit to the displacement data as a function of time. The processing unit is configured to determine a time of breaking of contact of the moveable contact with the fixed contact, the determination comprises a determination of a region of the displacement curve as a function of time. The determination of the region comprises a determination that a gradient of the region of the displacement curve as a function of time is greater than a gradient of the displacement curve as a function of time at a time earlier than a time associated with the region of the displacement curve as a function of time, and the determination of the region comprises a determination that the gradient of the region of the displacement curve as a function of time is greater than a gradient of the displacement curve as a function of time at a time later than the time associated with the region of the displacement curve as a function of time. The time associated with the region of the displacement curve as a function of time is determined as the time of breaking of contact of the moveable contact with the fixed contact. The output unit is configured to output the time of breaking of contact of the moveable contact with the fixed contact.

It is to be noted that the displacement data can be linear displacement data or angular/rotational displacement data.

Thus, the displacement curve generated from curve fitting can be a linear displacement curve as a function of time or be angular/rotational curve as a function of time.

It is to be noted that a determination that the gradient of the region of the displacement curve as a function of time is greater than a gradient of the displacement curve as a function of time at a time later than the time associated with the region of the displacement curve as a function of time refers to magnitudes of gradients. Thus, if displacement data were all multiplied by -1 the magnitude would still be greater than that either side.

Thus, the inventors established that the travel curve of a moveable contact during opening of a circuit breaker exhibited a small dent or point of inflexion or increase in gradient of the curve before the gradient decreased again and this dent represented the time point of the moveable contact breaking contact with the fixed contact, which is normally very difficult to establish. This then enables the opening time of the circuit breaker to be monitored accurately without also having to monitor current flow, where the opening time can be used as an indicator of the health of the circuit breaker, in other words if it is operating correctly. With reference to Fig. 2 the new technique enables the time region of breaking of contact only from the travel curves without knowing the current curves.

To put this another way the new technique utilizes an algorithm that can compute a time when contacts are no longer in contact, enabling opening times of circuit breakers to be determined, from the travel curve data by identifying a characteristic dent in the travel curve.

According to an example, the input unit is configured to receive a first time point associated with a time earlier than an estimated time of breaking of contact of the moveable contact with the fixed contact and receive a second time point associated with a time later than the estimated time of breaking of contact of the moveable contact from the fixed contact. The input unit is configured to provide the first time point and the second time point to the processing unit. The processing unit is configured to determine the displacement curve as a function of time by the curve fit to the displacement data as a function of time from the first time point to the second time point.

In this way, the curve fitting can be made over a shorter range of the real data, within which the dent is to be found, thereby increasing the accuracy of the curve fitting over the important region of breaking of contact "dent", to enable the time of breaking of contact of the contacts to be more accurately determined. The estimated time can be provided from general operational information for the circuit breaker.

According to an example, the determination of the curve fit to the displacement data as a function of time comprises utilization by the processing unit of a cubic spline process.

According to an example, the determination of the curve fit to the displacement data as a function of time comprises utilization by the processing unit of a cubic spline interpolation process.

According to an example, the processing unit is configured to generate a first derivative temporal curve of the displacement curve as a function of time, and wherein the determination of the region of the displacement curve as a function of time comprises utilization of the first derivative temporal curve.

Fig. 4 shows a system for determining a time of contact of contacts of a circuit breaker, the system comprising:
- a sensor 20;
- a processing unit 40; and
- an output unit 50.

The sensor is configured to acquire sensor data associated with a moveable contact of a circuit breaker 10 with respect to a fixed contact of the circuit breaker during a closing operation of the circuit breaker. The sensor data is displacement data as a function of time of the moveable contact with respect to the fixed contact of the circuit breaker during the closing operation of the circuit breaker. The sensor is configured to provide the displacement data as a function of time to the processing unit. The processing unit is configured to determine a displacement curve as a function of time, the displacement curve as a function of time is determined by a curve fit to the displacement data as a function of time. The processing unit is configured to determine a time of contact of the moveable contact with the fixed contact, the determination comprises a determination of a region of the displacement curve as a function of time. The determination of the region comprises a determination that a gradient of the region of the displacement curve as a function of time is less than a gradient of the displacement curve as a function of time at a time earlier than a time associated with the region of the displacement curve as a function of time, and the determination of the region comprises a determination that the gradient of the region of the displacement curve as a function of time is less than a gradient of the displacement curve as a function of time at a time later than the time associated with the region of the displacement curve as a function of time. The time associated with the region of the displacement curve as a function of time is determined as the time of contact of the moveable contact with the fixed contact. The output unit is configured to output the time of contact of the moveable contact with the fixed contact.

It is to be noted that the displacement data can be linear displacement data or angular/rotational displacement data.

Thus, the displacement curve generated from curve fitting can be a linear displacement curve as a function of time or be angular/rotational curve as a function of time.

It is to be noted that a determination that the gradient of the region of the displacement curve as a function of time is less than a gradient of the displacement curve as a function of time at a time later than the time associated with the region of the displacement curve as a function of time refers to magnitudes of gradients. Thus, if displacement data were all multiplied by -1 the magnitude would still be less than that either side.

In an example, the sensor is a displacement sensor.

In an example, the sensor is a rotation sensor.

In an example, the input unit is configured to receive a first time point associated with a time earlier than an estimated time of contact of the moveable contact with the fixed contact and receive a second time point associated with a time later than the estimated time of contact of the moveable contact with the fixed contact. The input unit is configured to provide the first time point and the second time point to the processing unit. The processing unit is configured to determine the displacement curve as a function of time by the curve fit to the displacement data as a function of time from the first time point to the second time point.

In an example the determination of the curve fit to the displacement data as a function of time comprises utilization by the processing unit of a cubic spline process.

In an example the determination of the curve fit to the displacement data as a function of time comprises utilization by the processing unit of a cubic spline interpolation process.

In an example the processing unit is configured to generate a first derivative temporal curve of the displacement curve as a function of time, and the determination of the region of the displacement curve as a function of time comprises utilization of the first derivative temporal curve.

Alternatively or additionally Fig. 4 shows a system for determining a time of breaking of contact of contacts of a circuit breaker, the system comprising:
- a sensor 20;
- a processing unit 40; and
- an output unit 50.

The sensor is configured to acquire sensor data associated with a moveable contact of a circuit breaker 10 with respect to a fixed contact of the circuit breaker during an opening operation of the circuit breaker. The sensor data is displacement data as a function of time of the moveable contact with respect to the fixed contact of the circuit breaker during the opening operation of the circuit breaker. The sensor is configured to provide the displacement data as a function of time to the processing unit. The processing unit is configured to determine a displacement curve as a function of time, the displacement curve as a function of time is determined by a curve fit to the displacement data as a function of time. The processing unit is configured to determine a time of breaking of contact of the moveable contact with the fixed contact, the determination comprises a determination of a region of the displacement curve as a function of time. The determination of the region comprises a determination that a gradient of the region of the displacement curve as a function of time is greater than a gradient of the displacement curve as a function of time at a time earlier than a time associated with the region of the displacement curve as a function of time, and the determination of the region comprises a determination that the gradient of the region of the displacement curve as a function of time is greater than a gradient of the displacement curve as a function of time at a time later than the time associated with the region of the displacement curve as a function of time. The time associated with the region of the displacement curve as a function of time is determined as the time of breaking of contact of the moveable contact with the fixed contact. The output unit is configured to output the time of breaking of contact of the moveable contact with the fixed contact.

It is to be noted that the displacement data can be linear displacement data or angular/rotational displacement data.

Thus, the displacement curve generated from curve fitting can be a linear displacement curve as a function of time or be angular/rotational curve as a function of time.

It is to be noted that a determination that the gradient of the region of the displacement curve as a function of time is greater than a gradient of the displacement curve as a function of time at a time later than the time associated with the region of the displacement curve as a function of time refers to magnitudes of gradients. Thus, if displacement data were all multiplied by -1 the magnitude would still be greater than that either side.

In an example, the sensor is a displacement sensor.

In an example, the sensor is a rotation sensor.

In an example, the input unit is configured to receive a first time point associated with a time earlier than an estimated time of breaking of contact of the moveable contact with the fixed contact and receive a second time point associated with a time later than the estimated time of breaking of contact of the moveable contact with the fixed contact. The input unit is configured to provide the first time point and the second time point to the processing unit. The processing unit is configured to determine the displacement curve as a function of time by the curve fit to the displacement data as a function of time from the first time point to the second time point.

In an example the determination of the curve fit to the displacement data as a function of time comprises utilization by the processing unit of a cubic spline process.

In an example the determination of the curve fit to the displacement data as a function of time comprises utilization by the processing unit of a cubic spline interpolation process.

In an example the processing unit is configured to generate a first derivative temporal curve of the displacement curve as a function of time, and wherein the determination of the region of the displacement curve as a function of time comprises utilization of the first derivative temporal curve.

From the above it is clear that a method for determining a time of contact of contacts of a circuit breaker comprises:
receiving by an input unit displacement data as a function of time of a moveable contact of a circuit breaker with respect to a fixed contact of the circuit breaker during a closing operation of the circuit breaker;
providing by the input unit the displacement data as a function of time to a processing unit;
determining by the processing unit a displacement curve as a function of time, wherein the displacement curve as a function of time is determined by a curve fit to the displacement data as a function of time;
determining by the processing unit a time of contact of the moveable contact with the fixed contact, wherein the determining comprises determining a region of the displacement curve as a function of time, wherein the determining the region comprises determining that a gradient of the region of the displacement curve as a function of time is less than a gradient of the displacement curve as a function of time at a time earlier than a time associated with the region of the displacement curve as a function of time, wherein the determining the region comprises determining that the gradient of the region of the displacement curve as a function of time is less than a gradient of the displacement curve as a function of time at a time later than the time associated with the region of the displacement curve as a function of time, and wherein the time associated with the region of the displacement curve as a function of time is determined as the time of contact of the moveable contact with the fixed contact; and
outputting by an output unit the time of contact of the moveable contact with the fixed contact.

It is to be noted that the displacement data can be linear displacement data or angular/rotational displacement data.

Thus, the displacement curve generated from curve fitting can be a linear displacement curve as a function of time or be angular/rotational curve as a function of time.

It is to be noted that a determination that the gradient of the region of the displacement curve as a function of time is less than a gradient of the displacement curve as a function of time at a time later than the time associated with the region of the displacement curve as a function of time refers to magnitudes of gradients. Thus, if displacement data were all multiplied by -1 the magnitude would still be less than that either side.

In an example, the method comprises receiving by the input unit a first time point associated with a time earlier than an estimated time of contact of the moveable contact with the fixed contact and receiving a second time point associated with a time later than the estimated time of contact of the moveable contact with the fixed contact, and providing by the input unit the first time point and the second time point to the processing unit, and wherein the method comprises determining by processing unit the displacement curve as a function of time by the curve fit to the displacement data as a function of time from the first time point to the second time point.

In an example, the determining the curve fit to the displacement data as a function of time comprises utilizing by the processing unit a cubic spline process.

In an example, the determining the curve fit to the displacement data as a function of time comprises utilizing by the processing unit a cubic spline interpolation process.

In an example, the method comprises generating by processing unit a first derivative temporal curve of the displacement curve as a function of time, and wherein the determining the region of the displacement curve as a function of time comprises utilizing the first derivative temporal curve.

It is also clear that a method for determining a time of breaking of contact of contacts of a circuit breaker comprises:
receiving by an input unit displacement data as a function of time of a moveable contact of a circuit breaker with respect to a fixed contact of the circuit breaker during an opening operation of the circuit breaker;
providing by the input unit the displacement data as a function of time to a processing unit;
determining by the processing unit a displacement curve as a function of time, wherein the displacement curve as a function of time is determined by a curve fit to the displacement data as a function of time;
determining by the processing unit a time of breaking of contact of the moveable contact with the fixed contact, wherein the determining comprises determining a region of the displacement curve as a function of time, wherein the determining the region comprises determining that a gradient of the region of the displacement curve as a function of time is greater than a gradient of the displacement curve as a function of time at a time earlier than a time associated with the region of the displacement curve as a function of time, wherein the determining the region comprises determining that the gradient of the region of the displacement curve as a function of time is greater than a gradient of the displacement curve as a function of time at a time later than the time associated with the region of the displacement curve as a function of time, and wherein the time associated with the region of the displacement curve as a function of time is determined as the time of breaking of contact of the moveable contact with the fixed contact; and
outputting by an output unit the time of breaking of contact of the moveable contact with the fixed contact.

It is to be noted that the displacement data can be linear displacement data or angular/rotational displacement data.

Thus, the displacement curve generated from curve fitting can be a linear displacement curve as a function of time or be angular/rotational curve as a function of time.

It is to be noted that a determination that the gradient of the region of the displacement curve as a function of time is greater than a gradient of the displacement curve as a function of time at a time later than the time associated with the region of the displacement curve as a function of time refers to magnitudes of gradients. Thus, if displacement data were all multiplied by -1 the magnitude would still be greater than that either side.

In an example, the method comprises receiving by the input unit a first time point associated with a time earlier than the time of breaking of contact of the moveable contact with the fixed contact and receiving a second time point associated with a time later than the time of breaking of contact of the moveable contact with the fixed contact, and providing by the input unit the first time point and the second time point to the processing unit, and wherein the method comprises determining by processing unit the displacement curve as a function of time by the curve fit to the displacement data as a function of time from the first time point to the second time point.

In an example, the determining the curve fit to the displacement data as a function of time comprises utilizing by the processing unit a cubic spline process.

In an example, the determining the curve fit to the displacement data as a function of time comprises utilizing by the processing unit a cubic spline interpolation process.

In an example, the method comprises generating by processing unit a first derivative temporal curve of the displacement curve as a function of time, and wherein the determining the region of the displacement curve as a function of time comprises utilizing the first derivative temporal curve.

The new apparatus, system and method for determining a time of contact of contacts of a circuit breaker, and the new apparatus, system and method for determining a time of breaking of contact of contacts of a circuit breaker are now described in specific detail for specific embodiments, where reference is made to Figs. 5-10.

Referring to Figs. 1-2 previously, the time instants for contact making or breaking were estimated by checking when a certain position in the travel curve is reached (any number between the steady states that makes physical sense for a particular model).

Fig. 5 shows an expanded portion of a travel curve during a closing operation showing a dent and an expanded portion of a travel curve during an opening operation showing a dent. In effect Fig. 5 shows expanded portion of Figs.1-2 around the times of t_{c21}/t_{c22} and the time of tₒ₂₁/tₒ₂₂.

It is to be noted that the displacement data can be linear displacement data or angular/rotational displacement data. Thus, the displacement curve generated from curve fitting can be a linear displacement curve as a function of time or be angular/rotational curve as a function of time.

The inventors established that the travel curves exhibit a small dent on the uprising or falling slope. The dent is found in the region around t_{c21} and t_{c22} or tₒ₂₁ and tₒ₂₂, which is shown in Fig. 5. This dent represents the point of contact or breaking of contact. It is barely visible and will easily disappear if denoising is applied. However, this inventors established that this dent represents the time instant at which the contact making or breaking occurs. Therefore, the dent is a very strong indicator for the detection of closing and opening times. Thus "dent detection" is a non-trivial but an important tool for breaker health monitoring.

Fig. 6 shows a system for a system for determining a time of contact (breaking of) of contacts of a circuit breaker 10 of a switchgear 100, where a travel curve sensor 20 acquires data for movement of the moveable contact that is provide to a processing unit 40, which is a device implementing the dent detection, and this result is provided to an output unit 50, which outputs the position of the dent on the travel curve, indicating the point of contact making or the point of breaking of contact.

In idealized data without noise, the dent that represents these points can be seen clearly. Mathematically, it is a small region where the gradient reaches its minimum, in extreme cases even zero or negative. However, due to noise, there might be other local minima that are of similar or greater scale than the actual dent. We propose to resolve this ambiguous situation through an intelligent cubic spline interpolation that removes the noise without affecting the dent itself.

Without noise, the simplest solution is simply look for the point with the lowest gradient in the slope section and identify that as the dent. However, due to noise, the gradient cannot be used in this way in most scenarios.

The inventors established that some sort of denoising is required to deal with the noise. Various filters could be used such as the Savitzky-Golay filter or polynomial fits. However, all of these solutions have a tendency to also remove the dent along with the noise. A spline-based solution was developed for a specific embodiment for curve fitting to the travel curve, but other curve fitting techniques can be utilized for denoising.

As shown in Figs. 7-8 for closing and opening operations the dent is identified that can be aided in determination through utilization of first derivative data. Thus, for the opening operation (see Fig. 8), the peak of the derivative is identified. The algorithm designed for the closing operation described in the next section can be trivially adapted for the opening case by looking for maxima rather than minima.

Referring to Figs. 9-10, the following denoising approach based on Cubic Spline interpolation was developed: First, the region of the slope is identified and isolated. Next, using a maximum and minimum value on the y axis, a region where the dent typically occurs is identified.

On this region, a cubic spline interpolation is performed. For this purpose, a suitable number of support points (possibly equidistant, possibly chosen by another algorithm) is defined. The spline is fitted through these points. For the new curve, the gradient is computed numerically or from the spline parameters. There will be one or more local minima in the gradient/derivative value. Typically, there will be three prominent cases representing the three phases. The average of these three can be taken. Alternatively, taking the most prominent or the first one will work with less accuracy.

For a situation where there is only one circuit breaker, then then there is only one travel curve, and no averaging is performed.

For the opening operation the curve looks almost the opposite. It starts at 1.0 and sees a steep downwards slope, also with a dent. The algorithm to find the dent is almost the same but we need to identify a maximum in the derivative instead of a minimum.

Other forms of splines could also be used, such as Bézier splines. Polynomial fits could be used although they tend to obscure the dent. Many types of denoising filters (SavGol and others) could be used.

In another exemplary embodiment, a computer program or computer program element is provided that is characterized by being configured to execute the method steps of the method according to one of the preceding embodiments, on an appropriate processor or system.

The computer program element might therefore be stored on a computer unit, which might also be part of an embodiment. This computing unit may be configured to perform or induce performing of the steps of the method described above. Moreover, it may be configured to operate the components of the above described system. The computing unit can be configured to operate automatically and/or to execute the orders of a user. A computer program may be loaded into a working memory of a data processor. The data processor may thus be equipped to carry out the method according to one of the preceding embodiments.

This exemplary embodiment of the invention covers both, a computer program that right from the beginning uses the invention and computer program that by means of an update turns an existing program into a program that uses the invention.

Further on, the computer program element might be able to provide all necessary steps to fulfill the procedure of an exemplary embodiment of the method as described above.

According to a further exemplary embodiment of the present invention, a computer readable medium, such as a CD-ROM, USB stick or the like, is presented wherein the computer readable medium has a computer program element stored on it which computer program element is described by the preceding section.

A computer program may be stored and/or distributed on a suitable medium, such as an optical storage medium or a solid state medium supplied together with or as part of other hardware, but may also be distributed in other forms, such as via the internet or other wired or wireless telecommunication systems.

However, the computer program may also be presented over a network like the World Wide Web and can be downloaded into the working memory of a data processor from such a network. According to a further exemplary embodiment of the present invention, a medium for making a computer program element available for downloading is provided, which computer program element is arranged to perform a method according to one of the previously described embodiments of the invention.

## Claims

1. An apparatus for determining a time of contact of contacts of a circuit breaker, the apparatus comprising:
- an input unit (30);
- a processing unit (40); and
- an output unit (50);
wherein the input unit is configured to receive displacement data as a function of time of a moveable contact of a circuit breaker (10) with respect to a fixed contact of the circuit breaker during a closing operation of the circuit breaker;
wherein the input unit is configured to provide the displacement data as a function of time to the processing unit;
wherein the processing unit is configured to determine a displacement curve as a function of time, wherein the displacement curve as a function of time is determined by a curve fit to the displacement data as a function of time;
wherein the processing unit is configured to determine a time of contact of the moveable contact with the fixed contact, wherein the determination comprises a determination of a region of the displacement curve as a function of time, wherein the determination of the region comprises a determination that a gradient of the region of the displacement curve as a function of time is less than a gradient of the displacement curve as a function of time at a time earlier than a time associated with the region of the displacement curve as a function of time, wherein the determination of the region comprises a determination that the gradient of the region of the displacement curve as a function of time is less than a gradient of the displacement curve as a function of time at a time later than the time associated with the region of the displacement curve as a function of time, and wherein the time associated with the region of the displacement curve as a function of time is determined as the time of contact of the moveable contact with the fixed contact; and
wherein the output unit is configured to output the time of contact of the moveable contact with the fixed contact.

2. Apparatus according to claim 1, wherein the input unit is configured to receive a first time point associated with a time earlier than an estimated time of contact of the moveable contact with the fixed contact and receive a second time point associated with a time later than the estimated time of contact of the moveable contact with the fixed contact, wherein the input unit is configured to provide the first time point and the second time point to the processing unit, and wherein the processing unit is configured to determine the displacement curve as a function of time by the curve fit to the displacement data as a function of time from the first time point to the second time point.

3. Apparatus according to any of claims 1-2, wherein the determination of the curve fit to the displacement data as a function of time comprises utilization by the processing unit of a cubic spline process.

4. Apparatus according to claim 3, wherein the determination of the curve fit to the displacement data as a function of time comprises utilization by the processing unit of a cubic spline interpolation process.

5. Apparatus according to any of claims 1-4, wherein the processing unit is configured to generate a first derivative temporal curve of the displacement curve as a function of time, and wherein the determination of the region of the displacement curve as a function of time comprises utilization of the first derivative temporal curve.

6. An apparatus for determining a time of breaking of contact of contacts of a circuit breaker, the apparatus comprising:
- an input unit (30);
- a processing unit (40); and
- an output unit (50);
wherein the input unit is configured to receive displacement data as a function of time of a moveable contact of a circuit breaker (10) with respect to a fixed contact of the circuit breaker during an opening operation of the circuit breaker;
wherein the input unit is configured to provide the displacement data as a function of time to the processing unit;
wherein the processing unit is configured to determine a displacement curve as a function of time, wherein the displacement curve as a function of time is determined by a curve fit to the displacement data as a function of time;
wherein the processing unit is configured to determine a time of breaking of contact of the moveable contact with the fixed contact, wherein the determination comprises a determination of a region of the displacement curve as a function of time, wherein the determination of the region comprises a determination that a gradient of the region of the displacement curve as a function of time is greater than a gradient of the displacement curve as a function of time at a time earlier than a time associated with the region of the displacement curve as a function of time, wherein the determination of the region comprises a determination that the gradient of the region of the displacement curve as a function of time is greater than a gradient of the displacement curve as a function of time at a time later than the time associated with the region of the displacement curve as a function of time, and wherein the time associated with the region of the displacement curve as a function of time is determined as the time of breaking of contact of the moveable contact with the fixed contact; and
wherein the output unit is configured to output the time of breaking of contact of the moveable contact with the fixed contact.

7. Apparatus according to claim 6, wherein the input unit is configured to receive a first time point associated with a time earlier than an estimated time of breaking of contact of the moveable contact with the fixed contact and receive a second time point associated with a time later than the estimated time of breaking of contact of the moveable contact from the fixed contact, wherein the input unit is configured to provide the first time point and the second time point to the processing unit, and wherein the processing unit is configured to determine the displacement curve as a function of time by the curve fit to the displacement data as a function of time from the first time point to the second time point.

8. Apparatus according to any of claims 6-7, wherein the determination of the curve fit to the displacement data as a function of time comprises utilization by the processing unit of a cubic spline process.

9. Apparatus according to claim 8, wherein the determination of the curve fit to the displacement data as a function of time comprises utilization by the processing unit of a cubic spline interpolation process.

10. Apparatus according to any of claims 6-9, wherein the processing unit is configured to generate a first derivative temporal curve of the displacement curve as a function of time, and wherein the determination of the region of the displacement curve as a function of time comprises utilization of the first derivative temporal curve.

11. A system for determining a time of contact of contacts of a circuit breaker, the system comprising:
- a sensor (20);
- a processing unit (40); and
- an output unit (50);
wherein the sensor is configured to acquire sensor data associated with a moveable contact of a circuit breaker (10) with respect to a fixed contact of the circuit breaker during a closing operation of the circuit breaker, wherein the sensor data is displacement data as a function of time of the moveable contact with respect to the fixed contact of the circuit breaker during the closing operation of the circuit breaker;
wherein the sensor is configured to provide the displacement data as a function of time to the processing unit;
wherein the processing unit is configured to determine a displacement curve as a function of time, wherein the displacement curve as a function of time is determined by a curve fit to the displacement data as a function of time;
wherein the processing unit is configured to determine a time of contact of the moveable contact with the fixed contact, wherein the determination comprises a determination of a region of the displacement curve as a function of time, wherein the determination of the region comprises a determination that a gradient of the region of the displacement curve as a function of time is less than a gradient of the displacement curve as a function of time at a time earlier than a time associated with the region of the displacement curve as a function of time, wherein the determination of the region comprises a determination that the gradient of the region of the displacement curve as a function of time is less than a gradient of the displacement curve as a function of time at a time later than the time associated with the region of the displacement curve as a function of time, and wherein the time associated with the region of the displacement curve as a function of time is determined as the time of contact of the moveable contact with the fixed contact; and
wherein the output unit is configured to output the time of contact of the moveable contact with the fixed contact.

12. A system for determining a time of breaking of contact of contacts of a circuit breaker, the system comprising:
- a sensor (20);
- a processing unit (40); and
- an output unit (50);
wherein the sensor is configured to acquire sensor data associated with a moveable contact of a circuit breaker (10) with respect to a fixed contact of the circuit breaker during an opening operation of the circuit breaker, wherein the sensor data is displacement data as a function of time of the moveable contact with respect to the fixed contact of the circuit breaker during the opening operation of the circuit breaker;
wherein the sensor is configured to provide the displacement data as a function of time to the processing unit;
wherein the processing unit is configured to determine a displacement curve as a function of time, wherein the displacement curve as a function of time is determined by a curve fit to the displacement data as a function of time;
wherein the processing unit is configured to determine a time of breaking of contact of the moveable contact with the fixed contact, wherein the determination comprises a determination of a region of the displacement curve as a function of time, wherein the determination of the region comprises a determination that a gradient of the region of the displacement curve as a function of time is greater than a gradient of the displacement curve as a function of time at a time earlier than a time associated with the region of the displacement curve as a function of time, wherein the determination of the region comprises a determination that the gradient of the region of the displacement curve as a function of time is greater than a gradient of the displacement curve as a function of time at a time later than the time associated with the region of the displacement curve as a function of time, and wherein the time associated with the region of the displacement curve as a function of time is determined as the time of breaking of contact of the moveable contact with the fixed contact; and
wherein the output unit is configured to output the time of breaking of contact of the moveable contact with the fixed contact.

13. A method for determining a time of contact of contacts of a circuit breaker, the method comprising:
receiving by an input unit displacement data as a function of time of a moveable contact of a circuit breaker with respect to a fixed contact of the circuit breaker during a closing operation of the circuit breaker;
providing by the input unit the displacement data as a function of time to a processing unit;
determining by the processing unit a displacement curve as a function of time, wherein the displacement curve as a function of time is determined by a curve fit to the displacement data as a function of time;
determining by the processing unit a time of contact of the moveable contact with the fixed contact, wherein the determining comprises determining a region of the displacement curve as a function of time, wherein the determining the region comprises determining that a gradient of the region of the displacement curve as a function of time is less than a gradient of the displacement curve as a function of time at a time earlier than a time associated with the region of the displacement curve as a function of time, wherein the determining the region comprises determining that the gradient of the region of the displacement curve as a function of time is less than a gradient of the displacement curve as a function of time at a time later than the time associated with the region of the displacement curve as a function of time, and wherein the time associated with the region of the displacement curve as a function of time is determined as the time of contact of the moveable contact with the fixed contact; and
outputting by an output unit the time of contact of the moveable contact with the fixed contact.

14. A method for determining a time of breaking of contact of contacts of a circuit breaker, the method comprising:
receiving by an input unit displacement data as a function of time of a moveable contact of a circuit breaker with respect to a fixed contact of the circuit breaker during an opening operation of the circuit breaker;
providing by the input unit the displacement data as a function of time to a processing unit;
determining by the processing unit a displacement curve as a function of time, wherein the displacement curve as a function of time is determined by a curve fit to the displacement data as a function of time;
determining by the processing unit a time of breaking of contact of the moveable contact with the fixed contact, wherein the determining comprises determining a region of the displacement curve as a function of time, wherein the determining the region comprises determining that a gradient of the region of the displacement curve as a function of time is greater than a gradient of the displacement curve as a function of time at a time earlier than a time associated with the region of the displacement curve as a function of time, wherein the determining the region comprises determining that the gradient of the region of the displacement curve as a function of time is greater than a gradient of the displacement curve as a function of time at a time later than the time associated with the region of the displacement curve as a function of time, and wherein the time associated with the region of the displacement curve as a function of time is determined as the time of breaking of contact of the moveable contact with the fixed contact; and
outputting by an output unit the time of breaking of contact of the moveable contact with the fixed contact.

15. A computer program element for controlling a system which when executed by a processor is configured to carry out the method of claim 13 and/or claim 14.
